Europäisches Patentamt

European Patent Office

Office européen des brevets

(19)

(11) **EP 0 990 160 B1**

(12) **EUROPÄISCHE PATENTSCHRIFT**

(45) Veröffentlichungstag und Bekanntmachung des Hinweises auf die Patenterteilung:
**28.11.2001 Patentblatt 2001/48**

(51) Int Cl.[7]: **G01R 15/18**, H01F 38/28

(21) Anmeldenummer: **98916789.5**

(86) Internationale Anmeldenummer:
**PCT/CH98/00199**

(22) Anmeldetag: **14.05.1998**

(87) Internationale Veröffentlichungsnummer:
**WO 98/58267 (23.12.1998 Gazette 1998/51)**

(54) **RINGKERN-STROMWANDLER MIT INTEGRIERTEM MESSSHUNT**

TOROIDAL CORE CURRENT TRANSFORMER WITH INTEGRATED MEASURING SHUNT

TRANSFORMATEUR TOROIDAL DE COURANT A SHUNT DE MESURE INTEGRE

(84) Benannte Vertragsstaaten:
**BE CH DE ES FI FR IT LI SE**

(30) Priorität: **16.06.1997 CH 146997**

(43) Veröffentlichungstag der Anmeldung:
**05.04.2000 Patentblatt 2000/14**

(73) Patentinhaber: **Trench Switzerland AG**
**4028 Basel (CH)**

(72) Erfinder:
• **MINKNER, Ruthard**
**CH-4148 Pfeffingen (CH)**
• **SCHMID, Joachim**
**D-79588 Efringen-Kirchen (DE)**

(74) Vertreter: **Bollhalder, Renato et al**
**A. Braun**
**Braun Héritier Eschmann AG**
**Patentanwälte VSP**
**Holbeinstrasse 36-38**
**4051 Basel (CH)**

(56) Entgegenhaltungen:
**EP-A- 0 723 159**     **EP-A- 0 828 265**
**GB-A- 2 201 249**     **US-A- 3 701 003**
**US-A- 3 885 213**     **US-A- 5 185 684**

**Beschreibung**

Die Erfindung betrifft einen Ringkern-Stromwandler mit-Spannungsausgang für die Messung eines Primärstromes $I_P$ insbesondere in Mittel- und Hochspannungsanlagen, wie er im Oberbegriff des unabhängigen Patentanspruchs 1 definiert ist.

Stromwandler können dazu eingesetzt werden, einen hohen Primärstrom $I_P$ in einem Primärleiter mittels eines Magnetkerns in einen vielfach niedrigeren Sekundärstrom $I_S$ in einer Sekundärwicklung um den Magnetkern umzuwandeln. Standard-Stromwandler werden heute im allgemeinen nach den IEC Stromwandler-Normen 185 (44-1) und 44-6, Stand Juli 1996, unter Berücksichtigung der zusätzlich geltenden Länderstandards ausgelegt und haben je nach Anforderungen des Benutzers Ausgangsströme von 1 A oder 5 A und je nach Art der eingesetzten Schutzrelais, Leistungszähler und Messgeräte etc. Bürden von 0,05 VA bis 10 VA. Als Bürde wird dabei die Impedanz bezeichnet, die am Sekundärkreis angeschlossen ist.

Durch das Aufkommen von auf Mikroprozessortechnologie basierenden neuen Schutzsystemen, Zählern und Messgeräten ist der Leistungsbedarf drastisch zurückgegangen, so dass auch die hierfür verwendeten Stromwandler auf diesen sehr geringen Leistungsbedarf ausgelegt werden konnten.

Die heute üblichen elektronischen Systeme verarbeiten eine maximale Eingangsspannung von ± 10 V, die dem vollverlagerten Kurzschlussstrom entspricht. Dies entspricht beim thermischen 1 Sekunde-Kurzschlussstrom einer Spannung von

$$\pm \frac{10\,V}{2\sqrt{2}} = \pm\,3{,}54\ V.$$

Die erforderliche Leistung bei einem Eingangswiderstand von 1 MΩ beträgt dann

$$P_{S_1} = \frac{\left(\dfrac{10\,V}{2\sqrt{2}}\right)}{1\,M\Omega} \approx 0{,}01\ mW.$$

Der geringe Leistungsbedarf bedeutet, dass die Schutzsysteme, Zähler und Messgeräte sehr hochohmig und somit gegen Einkopplungen von externen Störungen empfindlich sind.

Im folgenden werden zwei Stromwandler des Standes der Technik unter Bezugnahme auf die beigefügten Zeichnungen detaillierter beschrieben. Es zeigen:

Fig. 1 - ein Schaltbild eines ersten bekannten Stromwandlers mit angeschlossener Bürde $R_b$ und angeschlossener Benutzerschaltung und

Fig. 2 - ein Schaltbild eines zweiten bekannten Stromwandlers mit angeschlossener Benutzerschaltung mit Bürde $R_b$.

Figur 1

Stromwandler der hier dargestellten Art sind beispielsweise in der US-A-5 185 684 und in der US-A-3 701 003 beschrieben. Der Stromwandler umfasst einen Primärleiter 101, durch den ein Primärstrom $I_p$ fliesst, einen Sekundärleiter 102, durch den ein induzierter Sekundärstrom $I_s$ fliesst, eine Bürde $R_b$ sowie zwei Anschlüsse 103 und 104. Nicht gezeigt ist der Magnetkern des Stromwandlers, der vorzugsweise als Ringkern ausgebildet ist. Der Primärleiter 101 durchquert dann beispielsweise als Einstab-Primärleiter den Ringkern, der vom Sekundärleiter 102 umwickelt ist. Die Bürde $R_b$ kann in der Praxis z.B, im Klemmkasten eingebaut sein. An den Stromwandler angeschlossen ist eine Übertragungseinrichtung 110, z.B. ein Kabel, und an diese über zwei Anschlüsse 121 und 122 eine Benutzerschaltung 120 mit zwei Eingangswiderständen $R_{e1}$ und $R_{e2}$.

Die schraffierte Fläche A stellt den Bereich dar, in dem Störspannungen induziert werden können, die eine Messung des Primärstroms $I_P$ durch Messung der Spannung $U_s$ über der Bürde $R_b$ verfälschen.

Für die gesamte weitere Beschreibung gilt folgende Festlegung. Sind in einer Figur zum Zweck zeichnerischer Eindeutigkeit Bezugsziffern enthalten, aber im unmittelbar zugehörigen Beschreibungstext nicht erläutert, so wird auf deren Erwähnung in vorangehenden Figurenbeschreibungen Bezug genommen.

Figur 2

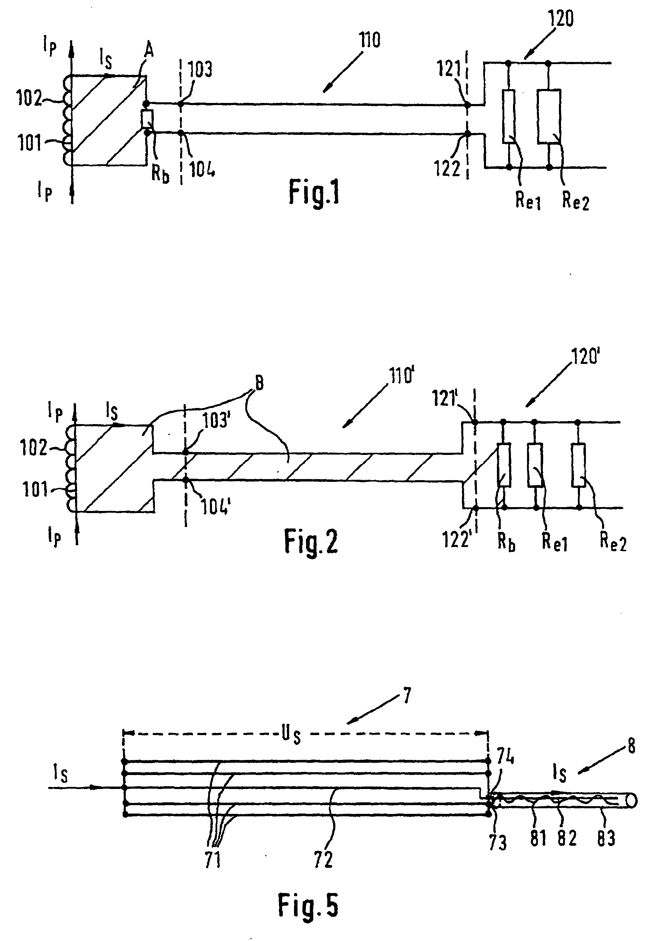

Dieser zweite Stromwandler unterscheidet sich vom in Fig. 1 dargestellten dadurch, dass die Bürde $R_b$ nicht direkt an ihm angeschlossen, sondern in einer Benutzerschaltung 120' angeordnet ist. Die Benutzerschaltung 120' ist mittels zweier Anschlüsse 121' und 122' über eine Übertragungseinrichtung 110' an zwei Anschlüsse 103' und 104' des Stromwandlers angeschlossen.

Die schraffierte Fläche B stellt den Bereich dar, in dem Störspannungen induziert werden können, die eine Messung des Primärstroms $I_p$ durch Messung der Spannung $U_s$ über der Bürde $R_b$ verfälschen.

Die in Fig. 1 und 2 dargestellten Schaltungen weisen beide den Nachteil auf, dass Sie empfindlich gegen Einkopplung von externen Störungen sind. Dies ist auch dann der Fall, wenn ein sehr niedriger Bürdenwiderstand $R_b$, z.B. $R_b \leq 1\ \Omega$, und bei der Sekundärwicklung verdrillte Ausgangsleiter verwendet werden, da die schraffierten Flächen A bzw. B potentielle Störspannungsinduzierungsbereiche darstellen.

Der Erfindung liegt daher die Aufgabe zugrunde, einen Ringkern-Stromwandler der eingangs erwähnten Art zu schaffen, der bedeutend weniger empfindlich gegen Einkopplung von externen Störungen ist als vergleichbare bekannte Ringkern-Stromwandler mit externer Bürde $R_b$.

Diese Aufgabe wird durch den erfindungsgemässen Ringkern-Stromwandler gelöst, wie er im unabhängigen Patentanspruch 1 definiert ist. Bevorzugte Ausführungsvarianten ergeben sich aus den abhängigen Patentansprüchen.

Das Wesen der Erfindung besteht darin, dass bei einem Ringkern-Stromwandler mit einem Primärleiter, der einen Ringkern durchquert, und einer um den Ringkern gewickelten Sekundärwicklung, die Sekundärwicklung kurzgeschlossen ist und ein Teil der Sekundärwicklung als Messshunt ausgebildet ist. Der Ringkern-Stromwandler weist einen Spannungsausgang für die Messung eines Primärstromes $I_p$, insbesondere in Mittel- und Hochspannungsanlagen, auf.

Beim erfindungsgemässen Ringkern-Stromwandler ist die Bürde $R_b$ als Röhren- oder Drahtmessshunt in die Sekundärwicklung integriert und wird hier mit $R_{wsh}$ bezeichnet. Die in den Fig. 1 und 2 mit A bzw. B bezeichneten Flächen magnetischer Einkopplung sind nicht mehr vorhanden, so dass der Ringkern-Stromwandler bedeutend weniger empfindlich gegen Einkopplung von externen Störungen ist.

Der Messshunt bildet $N_{ssh}$ Windungen der Sekundärwicklung, während die restlichen $N_{sl}$ Windungen durch den hier Sekundärleiter genannten Leiter ausserhalb des Messshunts gebildet werden. Die Windungszahl der Sekundärwicklung ist also $N_s = N_{sl}+N_{ssh}$, wobei normalerweise $N_{sl} \gg N_{ssh}$ ist. Der im Ringkern-Stromwandler fliessende Sekundärstrom wird durch den Primärstrom $I_p$ und die Windungszahl $N_s$ bestimmt. Der integrierte Messshunt stellt eine ideale störungsfreie Spannungsquelle dar, dessen Spannung proportional dem Primärstrom $I_p$ dividiert durch die Windungszahl $N_s = N_{sl}+N_{ssh}$ ist.

Der Messshunt weist einen Widerstandsleiter auf, der den Sekundärstrom $I_s$ zwischen den beiden Anschlüssen des Sekundärleiters führt, sowie einen Innenleiter für die Messung des durch den Sekundärstrom $I_s$ bewirkten Spannungsabfalls $U_s$ entlang dieses Widerstandsleiters. Der Widerstandsleiter wird z.B. durch eine Röhrenwandung, eine Abschirmung eines Kabels oder Widerstandsdrähte gebildet.

Der Widerstandsleiter besteht vorzugsweise aus einem Widerstandsmaterial mit einem Temperaturkoeffizienten $\leq \pm 5 \cdot 10^{-6}$ K$^{-1}$. Ein solches Widerstandsmaterial gewährleistet eine genaue und temperaturunabhängige Messung des Sekundärstroms $I_s$ in einem Temperaturbereich von -50 °C bis +100 °C. Als besonders geeignet haben sich die Legierungen *ISAOHM®* der Firma Isabellenhütte, Dillenburg/ Deutschland, und *Nikrothal LX* der Firma Bulten-Kanthal AB, Kanthal/Schweden, erwiesen.

Der Sekundärleiter besteht vorzugsweise aus Kupfer, während der Ringkern mit Vorteil aus magnetisch weichem Eisen besteht und je nach Anforderung keinen, einen oder mehrere Luftspalte haben kann.

Um eine kapazitive Einkopplung in den Ringkern-Stromwandler mit integriertem Messshunt möglichst weitgehend zu vermeiden, sollte der Ringkern-Stromwandler mit einer metallischen Abschirmung versehen oder in ein Metallgehäuse eingebaut werden, ohne dass eine Kurzschlusswindung entsteht. Der günstigste Punkt für die Erdung der Abschirmung oder des Gehäuses zur Minimierung der kapazitiv in das Messsystem eingekoppelten externen Störungen kann durch Messungen am Stromwandler ermittelt werden. Der Grad der kapazitiven Einkopplung ist bei niederohmigen Stromwandlern am kleinsten.

Im folgenden wird der erfindungsgemässe Ringkern-Stromwandler unter Bezugnahme auf die beigefügten Zeichnungen anhand von zwei Ausführungsbeispielen detaillierter beschrieben. Es zeigen:

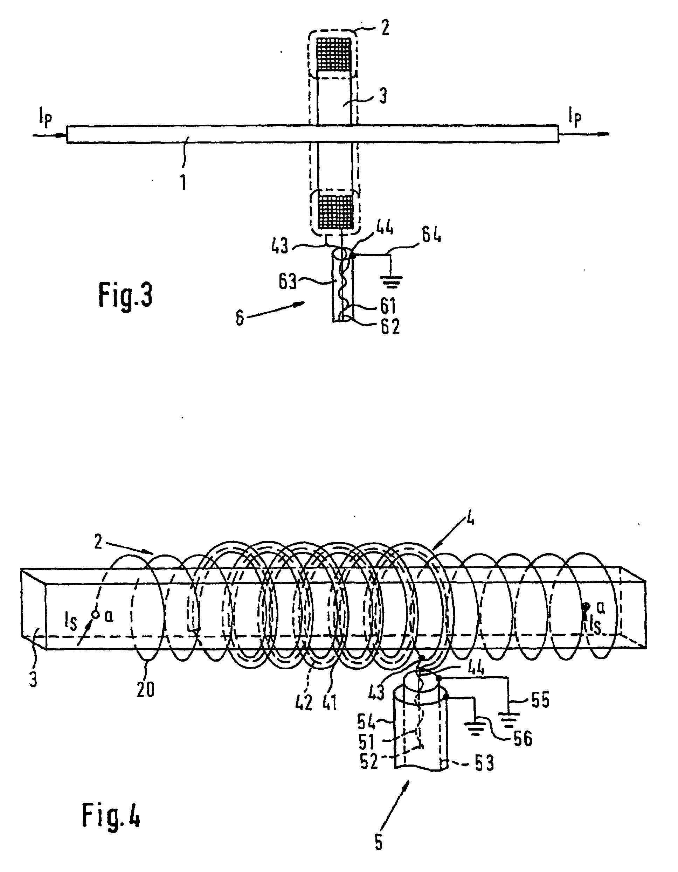

Fig. 3 - ein erstes Ausführungsbeispiel eines erfindungsgemässen Ringkern-Stromwandlers mit einem einfach abgeschirmten Anschlusskabel;

Fig. 4 - den Ringkern-Stromwandler von Fig. 3 ohne Primärleiter, aber mit einem doppelt abgeschirmten Anschlusskabel, wobei der Ringkern und die Sekundärwicklung aufgeschnitten und gestreckt dargestellt und nur eine Wicklungslage gezeichnet ist, und

Fig. 5 - ein zweites Ausführungsbeispiel eines erfindungsgemässen Messshunts mit einem einfach abgeschirmten Anschlusskabel.

<u>Figur 3</u>

Der dargestellte Ringkern-Stromwandler umfasst einen Primärleiter 1, der als Einstab-Primärleiter ausgebildet ist und von einem Primärstrom $I_P$ durchflossen wird. Der Primärleiter 1 durchquert einen Ringkern 3 aus magnetisch weichem Eisen, der keinen, einen oder mehrere Luftspalte aufweisen kann. Um den Ringkern 3 herum ist eine Sekundärwicklung 2 gewickelt, die sich aus einem Sekundärleiter und einem Messshunt zusammensetzt und in der ein Sekundärstrom $I_s$ induziert wird. Der Messshunt umfasst einen Widerstandsleiter, der den Sekundärstrom $I_s$ zwischen den beiden Anschlüssen des Sekundärleiters führt, sowie einen Innenleiter für die Messung des durch den Sekundärstrom $I_s$ bewirkten Spannungsabfalls $U_s$ entlang dieses Widerstandsleiters. Der Widerstandsleiter und der Innenleiter sind über einen Ausgangsleiter bzw. direkt mit Ausgangsanschlüssen 43 bzw. 44 versehen.

An die Ausgangsanschlüsse 43 und 44 des Messshunts angeschlossen ist ein einfach abgeschirmtes Anschlusskabel 6 mit zwei verdrillten Innenleitern 61 und 62 sowie einer Abschirmung 63, die durch eine Erdung 64 geerdet ist.

### Figur 4

Der Ringkern 3 und die Sekundärwicklung 2 des Stromwandlers von Fig. 3 sind hier aufgeschnitten und gestreckt im Detail dargestellt, wobei nur eine Wicklungslage gezeichnet ist, normalerweise aber mehrere Wicklungslagen übereinander liegen.

Die Sekundärwicklung 2 weist einen Sekundärleiter 20 und einen Röhrenmessshunt 4 auf. Die beiden Punkte a des Sekundärleiters 20 ergeben sich durch das Aufschneiden und Strecken des Ringkerns 3 und der Sekundärwicklung 2, fallen aber in Wirklichkeit zusammen. Die Windungszahl der Sekundärwicklung 2 ist $N_s$, wobei $N_{ssh}$ Windungen durch den Röhrenmessshunt 4 und die restlichen $N_{sl} = N_s\text{-}N_{ssh}$ Windungen durch den Sekundärleiter 20 gebildet werden. Normalerweise ist $N_{sl} >> N_{ssh}$, z.B. $N_{sl}$ = 1495 und $N_{ssh}$ = 5.

Der Röhrenmessshunt 4 umfasst eine Röhrenwandung 41 als den Sekundärstrom $I_s$ führenden Widerstandsleiter und einen Innenleiter 42 für die Messung des durch den Sekundärstrom $I_s$ bewirkten Spannungsabfalls $U_s$ entlang der Röhrenwandung 41.

Die Röhrenwandung 41 ist beispielsweise ein metallisches Röhrchen oder die Abschirmung eines Kabels und ist sowohl am Anfang als auch am Ende mit dem Sekundärleiter 20 verbunden. Über einen Ausgangsleiter weist sie den Ausgangsanschluss 43 auf.

Der Innenleiter 42 ist innerhalb der Röhrenwandung 41 konzentrisch und isoliert angeordnet und nur am Anfang mit dem Sekundärleiter 20 verbunden. Am Ende ist er mit dem Ausgangsanschluss 44 versehen.

An die Ausgangsanschlüsse 43 und 44 des Röhrenmessshunts 4 angeschlossen ist ein doppelt abgeschirmtes Anschlusskabel 5 mit zwei verdrillten Innenleitern 51 und 52 sowie einer inneren Abschirmung 53 und einer äusseren Abschirmung 54, die durch Erdungen 55 bzw. 56 geerdet sind.

Um eine magnetische Einkopplung möglichst vollständig zu verhindern, sollten der Ausgangsleiter der Röhrenwandung 41 und der Innenleiter 42 direkt am Ende des Röhrenmessshunts 4 verdrillt werden. Um eine kapazitive Einkopplung zu vermeiden, sollten die beiden Abschirmungen 53 und 54 des doppelt abgeschirmten Kabels 5 direkt bis zum Ende des Röhrenmessshunts 4 geführt werden.

### Figur 5

Das zweite Ausführungsbeispiel eines erfindungsgemässen Messshunts ist ein verdrillter Drahtmessshunt 7 mit vier Widerstandsdrähten 71 und einem Innenleiter 72 für die Messung des durch den Sekundärstrom $I_s$ bewirkten Spannungsabfalls $U_s$ entlang der Widerstandsdrähte 71. Die Widerstandsdrähte 71 und der Innenleiter 72 sind eigentlich miteinander verdrillt, hier aber aus Übersichtlichkeitsgründen unverdrillt dargestellt. Die vier Widerstandsdrähte 71 führen zusammen den Sekundärstrom $I_s$ und erzeugen die Spannung $U_s = 4 \cdot \frac{I_s}{4} \cdot R_{wsh}$, wobei $R_{wsh}$ der Drahtmessshuntwiderstand zwischen den beiden Anschlüssen an den Sekundärleiter ist. Die Widerstandsdrähte 71 weisen über einen Ausgangsleiter einen Ausgangsanschluss 73 und der Innenleiter 72 einen Ausgangsanschluss 74 auf.

An die Ausgangsanschlüsse 73 und 74 des Drahtmessshunts 7 angeschlossen ist ein einfach abgeschirmtes Anschlusskabel 8 mit zwei verdrillten Innenleitern 81 und 82 sowie einer Abschirmung 83.

Zu den vorbeschriebenen erfindungsgemässen Ringkern-Stromwandlern sind im Rahmen der Patentansprüche selbstverständlich weitere konstruktive Variationen realisierbar.

## Patentansprüche

1. Ringkern-Stromwandler mit Spannungsausgang für die Messung eines Primärstromes $I_p$ insbesondere in Mittel- und Hochspannungsanlagen, mit einem Primärleiter (1), der einen Ringkern (3) durchquert, und einer um den Ringkern (3) gewickelten Sekundärwicklung (2), **dadurch gekennzeichnet, dass** die Sekundärwicklung (2) kurzgeschlossen ist und ein Teil der Sekundärwicklung (2) als Messshunt (4;7) ausgebildet ist.

2. Ringkern-Stromwandler nach Anspruch 1, **dadurch gekennzeichnet, dass** der Messshunt ein Röhrenmessshunt (4) mit einer Röhrenwandung (41) und einem Innenleiter (42) für die Messung des durch den Sekundärstrom $I_s$ bewirkten Spannungsabfalls $U_s$ entlang der Röhrenwandung (41) ist.

3. Ringkern-Stromwandler nach Anspruch 2, **dadurch gekennzeichnet, dass** die Röhrenwandung (41) ein metallisches Röhrchen und der Innenleiter (42) im Röhrchen konzentrisch und isoliert angeordnet ist.

4. Ringkern-Stromwandler nach Anspruch 2, **dadurch gekennzeichnet, dass** der Röhrenmessshunt (4) ein abgeschirmtes Kabel mit einem konzentrisch und isoliert angeordneten Innenleiter (42) ist.

5. Ringkern-Stromwandler nach Anspruch 4, **dadurch gekennzeichnet, dass** die Abschirmung des Kabels ein Geflecht aus dünnen Drähten ist und als Stromleiter für den Sekundärstrom $I_s$ wirkt.

6. Ringkern-Stromwandler nach Anspruch 1, **dadurch gekennzeichnet, dass** der Messshunt ein verdrillter Drahtmessshunt (7) mit einem oder mehreren Widerstandsdrähten (71) und einem Innenleiter (72) für die Messung des durch den Sekundärstrom $I_s$ bewirkten Spannungsabfalls $U_s$ entlang der Widerstandsdrähte (71) ist.

7. Ringkern-Stromwandler nach einem der Ansprüche 2 bis 6, **dadurch gekennzeichnet, dass** die Röhrenwandung (41) bzw. die Abschirmung des Kabels bzw. die Widerstandsdrähte (71) aus einem Widerstandsmaterial mit einem Temperaturkoeffizienten $\leq \pm 5 \cdot 10^{-6}$ $K^{-1}$ bestehen.

8. Ringkern-Stromwandler nach einem der Ansprüche 2 bis 7, **dadurch gekennzeichnet, dass** die Röhrenwandung (41) bzw. die Abschirmung des Kabels bzw. die Widerstandsdrähte (71) aus einer Legierung, die

> 74,5% Ni,
> 20% Cr,
> 3,5% Al,
> 0,5% Mn,
> 0,5% Fe und
> 1% sonstiges umfasst,

insbesondere aus *ISAOHM®* bestehen.

9. Ringkern-Stromwandler nach einem der Ansprüche 2 bis 7, **dadurch gekennzeichnet, dass** die Röhrenwandung (41) bzw. die Abschirmung des Kabels bzw. die Widerstandsdrähte (71) aus einer Legierung, die

> 75% Ni,
> 20% Cr und
> 5% sonstiges umfasst,

insbesondere aus *Nikrothal LX* bestehen.

10. Ringkern-Stromwandler nach einem der Ansprüche 1 bis 9, **dadurch gekennzeichnet, dass** der Primärleiter (1) ein Einstab-Primärleiter ist und der Ringkern (3) aus magnetisch weichem Eisen besteht.

**Claims**

1. Toroidal core current transformer having a voltage output for measurement of a primary current $I_p$, in particular in medium-voltage and high-voltage systems, having a primary conductor (1) which passes through a toroidal core (3), and having a secondary winding (2) which is wound around the toroidal core (3), **characterized in that** the secondary winding (2) is short-circuited, and a portion of the secondary winding (2) is in the form of a measurement shunt (4; 7).

2. Toroidal core current transformer according to Claim 1, **characterized in that** the measurement shunt is a tubular measurement shunt (4) having a tube wall (41) and an inner conductor (42) for measurement of the voltage drop $U_s$, produced by the secondary current $I_s$, along the tube wall (41).

3. Toroidal core current transformer according to Claim 2, **characterized in that** the tube wall (41) is a metallic small tube, and the inner conductor (42) is arranged concentrically and in an insulated manner in the small tube.

4. Toroidal core current transformer according to Claim 2, **characterized in that** the tubular measurement shunt (4) is a screened cable having an inner conductor (42) which is arranged concentrically and in an insulated manner.

5. Toroidal core current transformer according to Claim 4, **characterized in that** the cable screen is a mesh composed of thin wires, and acts as a current conductor for the secondary current $I_s$.

6. Toroidal core current transformer according to Claim 1, **characterized in that** the measurement shunt is a twisted wire measurement shunt (7) having one or more resistance wires (71) and an inner conductor (72) for measuring the voltage drop $U_s$, produced by the secondary current $I_s$, along the resistance wires (71).

7. Toroidal core current transformer according to one of Claims 2 to 6, **characterized in that** the tube wall (41) or the cable screen or the resistance wires (71) are composed of a resistance material having a temperature coefficient of $< \pm 5 \cdot 10^{-6}$ $K^{-1}$.

8. Toroidal core current transformer according to one of Claims 2 to 7, **characterized in that** the tube wall (41) or the cable screen or the resistance wires (71) are composed of an alloy which comprises

> 74.5% Ni,
> 20% Cr,
> 3.5% Al,
> 0.5% Mn,
> 0.5% Fe and
> 1% other substances,

in particular *ISAOHM®*.

9. Toroidal core current transformer according to one of Claims 2 to 7, **characterized in that** the tube wall (41) or the cable screen or the resistance wires (71) are composed of an alloy which comprises

> 75% Ni,

20% Cr and
5% other substances,

in particular *Nikrothal LX.*

**10.** Toroidal core current transformer according to one of Claims 1 to 9, **characterized in that** the primary conductor (1) is a single-bar primary conductor, and the toroidal core (3) is composed of magnetically soft iron.


**Revendications**

**1.** Transformateur de courant toroïdal avec une sortie tension pour la mesure d'un courant primaire $I_P$, notamment dans les installations de moyenne et de haute tension, avec un conducteur primaire (1) qui traverse un tore (3) et un enroulement secondaire (2) bobiné autour du tore (3), **caractérisé en ce que** l'enroulement secondaire (2) est court-circuité et une partie de l'enroulement secondaire (2) est réalisée sous la forme d'un shunt de mesure (4; 7).

**2.** Transformateur de courant toroïdal selon la revendication 1, **caractérisé en ce que** le shunt de mesure est un shunt de mesure tubulaire (4) comprenant une paroi tubulaire (41) et une âme conductrice (42) pour la mesure de la chute de tension $U_s$ provoquée par le courant secondaire $I_s$ le long de la paroi tubulaire (41).

**3.** Transformateur de courant toroïdal selon la revendication 2, **caractérisé en ce que** la paroi tubulaire (41) est un petit tube métallique et l'âme conductrice (42) est isolée et logée de manière concentrique dans le petit tube.

**4.** Transformateur de courant toroïdal selon la revendication 2, **caractérisé en ce que** le shunt de mesure tubulaire (4) est un câble blindé muni d'une âme conductrice (42) isolée et disposée de manière concentrique.

**5.** Transformateur de courant toroïdal selon la revendication 4, **caractérisé en ce que** le blindage du câble est une tresse de fils minces et fait office de conducteur pour le courant secondaire $I_s$.

**6.** Transformateur de courant toroïdal selon la revendication 1, **caractérisé en ce que** le shunt de mesure est un shunt de mesure filaire torsadé (7) comprenant un ou plusieurs fils résistifs (71) et une âme conductrice (72) pour la mesure de la chute de tension $U_s$ provoquée par le courant secondaire $I_s$ le long des fils résistifs (71).

**7.** Transformateur de courant toroïdal selon l'une des revendications 2 à 6, **caractérisé en ce que** la paroi tubulaire (41) ou le blindage du câble ou les fils résistifs (71) sont réalisés dans un matériau résistif ayant un coefficient de température $\leq \pm 5 \cdot 10^{-6}$ $K^{-1}$.

**8.** Transformateur de courant toroïdal selon l'une des revendications 2 à 7, **caractérisé en ce que** la paroi tubulaire (41) ou le blindage du câble ou les fils résistifs (71) sont réalisés dans un alliage qui comprend 74,5% de Ni, 20% de Cr, 3,5% d'Al, 0,5% de Mn, 0,5% de Fe et 1% de substances diverses, plus précisément de l'ISAOHM® .

**9.** Transformateur de courant toroïdal selon l'une des revendications 2 à 7, **caractérisé en ce que** la paroi tubulaire (41) ou le blindage du câble ou les fils résistifs (71) sont réalisés dans un alliage qui comprend 75% de Ni, 20% de Cr et 5% de substances diverses, plus précisément du Nikrothal LX.

**10.** Transformateur de courant toroïdal selon l'une des revendications 1 à 9, **caractérisé en ce que** le conducteur primaire (1) est un conducteur primaire à une seule barre et le tore (3) est réalisé dans un fer doux magnétique.

Fig.1

Fig.2

Fig.5

Fig.3

Fig.4